# EUROPÄISCHE PATENTSCHRIFT

(11) **EP 3 715 878 B1**
(45) Veröffentlichungstag und Bekanntmachung des Hinweises auf die Patenterteilung: **02.08.2023**
(21) Anmeldenummer: 19165665.1
(22) Anmeldetag: 28.03.2019
(51) Int. Cl.: G01R 31/62, H01F 27/40

(54) **VERFAHREN ZUM BESTIMMEN DER ÜBERLASTFÄHIGKEIT EINES HOCHSPANNUNGSGERÄTS**
METHOD FOR DETERMINING THE OVERLOAD CAPABILITY OF A HIGH VOLTAGE DEVICE
PROCÉDÉ DE DÉTERMINATION DE LA CAPACITÉ DE SURCHARGE D'UN APPAREIL HAUTE TENSION

(43) Veröffentlichungstag der Anmeldung: 30.09.2020
(73) Patentinhaber: Siemens Energy Global GmbH & Co. KG, 81739 München (DE)
(72) Erfinder: Fritsche, Ronny, 90469 Nürnberg (DE); Hammer, Thomas, 91126 Schwabach (DE); Küstermann, Matthias, 90408 Nürnberg (DE); Raith, Johannes, 8162 Passail (AT)

(56) Entgegenhaltungen:
- WO-A1-2015/042793
- CN-A- 106 874 534
- US-A1- 2010 188 240
- US-A1- 2016 252 401

## Beschreibung

Die Erfindung betrifft Verfahren zum Bestimmen der Überlastfähigkeit eines Transformators, bei dem eine Lastvorhersageanfrage für einen vorgegebenen Zeitraum erstellt, ein Betriebszustand des Transformators unter Gewinnung von Zustandsparametern ermittelt wird, die Lastvorhersageanfrage und die Zustandsparameter in einem Anfragezeitpunkt an ein Lastvorhersagemodell übertragen werden und das Lastvorhersagemodell die maximale Auslastung in dem vorgegebenen Zeitraum ermittelt.

Ein solches Verfahren ist aus der US 2016/252401 A1 bereits bekannt. Dort wird eine obere Öltemperatur und eine obere Wicklungstemperatur aus gemessenen Stromwerten abgeleitet, die an der Primär- und an der Sekundärwicklung erfasst werden. Neben diesen gemessenen Wicklungsströmen werden dem bekannten Lastvorhersagemodell die in der Umgebung des Transformators gemessene Temperatur, die von einem Wetterdienst vorhergesagte Temperatur und eine vorhergesagte Überlast als Eingangsgrößen oder Zustandsparameter zu geführt.

Ein weiteres Lastvorhersagemodell ist in der CN 106 874 534 A beschrieben.

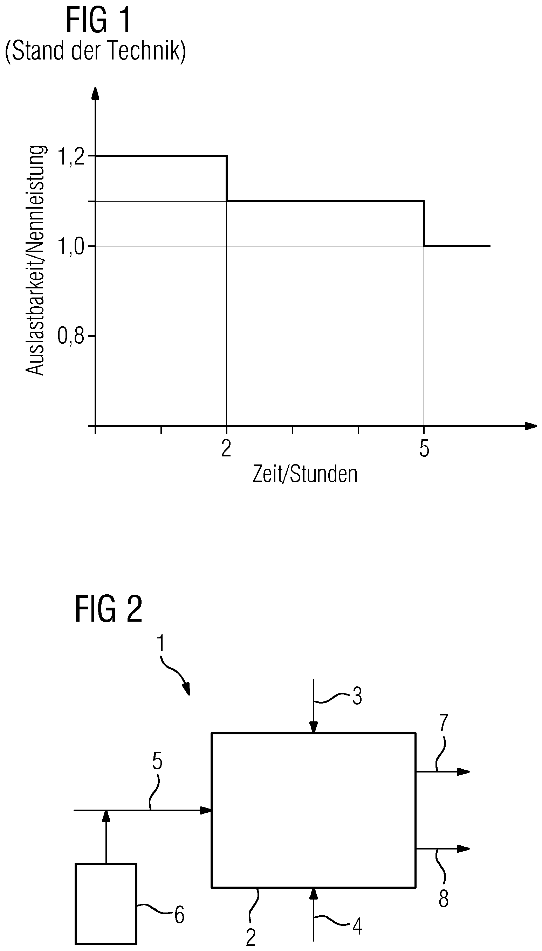

Technische oder wirtschaftliche Anforderungen machen es von Zeit zu Zeit erforderlich, Transformatoren in Überlast zu betreiben. Dies ist jedoch nur bis zu einem bestimmten Grad möglich, ohne den Transformator zu beschädigen. Eine gängige Darstellung der Überlastfähigkeit von Transformatoren erfolgt in Gestalt so genannter Überlastkurven. Überlastkurven werden statisch basierend auf der Spezifikation des jeweiligen Transformators erstellt. Der Überlastzeitraum ist in solchen statischen Überlastkurven vorab definiert und berücksichtigt nicht ein eventuell höheres Überlastpotential für kürzere Zeiträume. Eine Ermittlung der Überlastfähigkeit mit Hilfe von Überlastkurven wird später im Zusammenhang mit Figur 1 erläutert.

Aus der DE 10 2007 026 175 B4 ist ein Verfahren zum Ermitteln der Alterungsrate eines Transformators bekannt geworden. Gemäß dem vorbekannten Verfahren wird die Alterungsrate V_{IEC} eines Transformators nach dem IEC-Standard 60076-7 berechnet, wobei Sauerstoff- und Feuchteanteil der Isolierflüssigkeit des Transformators berücksichtigt werden.

Dem eingangs genannten Verfahren haftet der Nachteil an, dass der Betriebszustand des Energieversorgungsnetzes nur unzureichend ermittelt wird, so dass das Potential des Transformators, mit Überlast betrieben zu werden, nur unzureichend ausgeschöpft wird.

Aufgabe der Erfindung ist es daher, ein Verfahren der eingangs genannten Art zu schaffen, mit dessen Hilfe die Überlastfähigkeit eines Transformators voll ausgeschöpft werden kann.

Die Erfindung löst diese Aufgabe dadurch, dass eine vor dem Anfragezeitpunkt verbrauchte Lebensdauer des Transformators unter Gewinnung einer tatsächlich verbrauchten Lebensdauer von Messwerten abgeleitet wird und die tatsächlich verbrauchte Lebensdauer dem Lastvorhersagemodell als Zustandsparameter zugeführt wird, wobei das Lastvorhersagemodell die maximale Überlastfähigkeit in Abhängigkeit der tatsächlich verbrauchten Lebensdauer ermittelt.

Erfindungsgemäß wird die Überlastfähigkeit nicht länger auf der Grundlage eines grob abgeschätzten Überlastprofils ermittelt. Im Rahmen der Erfindung wird die verbleibende Lebensdauer des Transformators fortwährend oder in bestimmten zeitlichen Abständen berechnet und abgespeichert. Hierzu ist eine zweckmäßige Speichereinheit vorgesehen, die mit dem Lastvorhersagemodell im Anfragezeitpunkt verbindbar ist. Während bei den vorbekannten Verfahren die Kapazitäten des Transformators nicht vollständig ausgeschöpft wurden, ermöglicht die Erfindung, die Überlastfähigkeit des jeweiligen Transformators genauer zu ermitteln und das Potential des Transformators nahezu vollständig auszuschöpfen.

Gemäß einer diesbezüglichen Weiterentwicklung umfassen die Zustandsparameter einen Parameter, der die zur Verfügung stehende die Kühlleistung abbildet. Die Kühlleistung ist bei der Berechnung der Überlastfähigkeit eine besonders wichtige Größe, da diese die Temperatur der Isolierflüssigkeit maßgeblich mitbestimmt. Bei einer hohen Kühlleistung erwärmt sich das Isolierfluid weniger stark, und ermöglicht so einen Betrieb bei höherer Last. Als Parameter eignet sich im Rahmen der Erfindung ein dimensionsloser Zustandsparameter. Dazu wird die aktuelle zur Verfügung stehende Kühlleistung z.B. bezogen auf die Nennkühlleistung. Die Nennkühlleistung ist herstellerseitig angegeben.

Vorteilhafterweise umfassen die Zustandsparameter einen Parameter, der die Wetterbedingungen abbildet, denen der Transformator ausgesetzt ist. Eine weitere große Einflussgröße der Überlastfähigkeit und des Alterungsprozesses eines Transformators sind die Wetterbedingungen, die am Ort des Transformators herrschen. So erwärmt sich das Isolierfluid bei 35 Grad im Schatten und starker Sonnenbestrahlung beispielsweise schneller als in der Nacht bei Temperaturen unterhalb des Gefrierpunktes. Um die für den Anfragezeitpunkt vorausgesagten Wetterbedingungen zu erhalten, kann beispielsweise auf die Datenbank eines Wetterdienstes zugegriffen werden.

Gemäß einer diesbezüglichen Weiterentwicklung kann die Lastvorhersageanfrage eine Vorhersage der Wetterbedingungen umfassen. Gemäß dieser Variante, dann sich der Nutzer des erfindungsgemäßen Verfahrens selbst an einen Wetterdienst wenden, um die Wetterbedingungen in Erfahrung zu bringen und diese anschließend in seine Anfrage mit einzubringen.

Die verbrauchte Lebensdauer des Transformators kann fortwährend ermittelt und auf einer Speichereinheit abgelegt werden.

Zweckmäßigerweise umfasst die Lastvorhersaganfrage eine Angabe über den gewünschten Lebensdauerverbrauch. Diese Variante ermöglicht dem Nutzer, eine Bedingung in seine Anfrage einzuflechten. Diese Bedingung betrifft den gewünschten Lebensdauerverbrauch. Dies wird beispielsweise dann wichtig, wenn der Transformator bereits älter ist und eine nur noch geringe Lebensdauer aufweist. Der Nutzer versucht dann in der Regel den Lebensdauerverbrauch möglichst gering zu halten, um einen schnellen Ersatz des alten Transformators durch ein neues zu vermeiden.

Bei einer weiteren Variante der Erfindung werden Messwerte von Sensoren erfasst, die in oder an dem Transformator angeordnet sind, wobei die Zustandsparameter zumindest teilweise auf Grundlage der Messwerte und/oder der davon abgeleiteten Werte erhalten werden. Mit Hilfe von Messungen kann der Betriebszustand eines Transformators genau erfasst werden. Solche Messwerte und/oder davon abgeleitete Werte umfassen beispielsweise die Temperatur eines Isolierfluids im oberen und unteren Bereich eines Tanks eines Leistungstransformators und die Wicklungsströme, also die elektrischen Ströme, die über die Unter- und/oder Oberspannungswicklung fließen.

Zweckmäßigerweise werden Messwerte und/oder von den Messwerten abgeleitete Werte verwendet, die vor dem Anfragezeitpunkt erfasst beziehungsweise abgeleitet wurden. Mit Hilfe von Messwerten oder abgeleiteten Werten aus der Vergangenheit können so genannte dynamische Effekte berücksichtigt und sichtbar gemacht werden. Nimmt beispielsweise die Temperatur einer Isolierflüssigkeit eines Transformators nicht kontinuierlich, sondern sprunghaft z.B. von einer Minute auf die andere zu, so ist dies sicherlich ein Hinweis auf einen Fehler, der baldmöglichst behoben werden sollte. Solche sprunghaften Entwicklungen sollten jedoch bei der Modellierung der Überlastfähigkeit ausgeschlossen werden.

Die an oder in dem jeweiligen Transformator angeordneten Sensoren sind vorteilhafterweise über eine Nahbereichskommunikations-Verbindung mit einer Kommunikationseinheit verbunden. Die Nahbereichskommunikations-Verbindung kann beispielsweise ein einfaches Kabel sein. Abweichend davon ist die Nahbereichskommunikations-Verbindung beispielsweise eine ZigBee-, eine Bluetooth-, eine Wireless-, Ambus- oder eine WiFi-Kommunikationsverbindung. Die Nahbereichs-Kommunikationsverbindung erstreckt sich maximal über 100 Meter.

Die Kommunikationseinheit weist bevorzugt wenigstens einen analogen und wenigstens einen digitalen Eingang auf. Somit können mehrere Sensoren mit einer Kommunikationseinheit verbunden sein. Die Kommunikationseinheit verfügt beispielsweise über einen Haupt- und einen Nebenprozessor sowie über eine Speichereinheit, in der vorverarbeitete Messwerte oder daraus abgeleitete Werte abgelegt und bearbeitet werden können, z.B. durch Mittelwertbildung. Die Messwerte verschiedener Sensoren können daher gemeinsam von einer Kommunikationseinheit z.B. über eine Fernbereichskommunikationsverbindung an eine Datenverarbeitungs-Cloud gesendet werden.

Die Sensoren sind im Rahmen der Erfindung grundsätzlich beliebig ausgeführt. Vorteilhafterweise ist wenigstens ein Temperatursensor zum Erfassen der Temperatur des Isolierfluids und wenigstens ein Stromsensor zum Erfassen des Wicklungsstromes der Ober- oder Unterspannungswicklung vorgesehen.

Unter einer Datenverarbeitungs-Cloud soll hier eine Anordnung mit einer oder mehreren Datenspeichereinrichtungen und einer oder mehreren Datenverarbeitungseinrichtung verstanden werden, die durch geeignete Programmierung zur Durchführung beliebiger Datenverarbeitungsprozesse ausgebildet werden kann. Die Datenverarbeitungseinrichtungen stellen hierbei in der Regel universelle Datenverarbeitungseinrichtungen, wie beispielsweise Server, dar, die hinsichtlich ihrer Konstruktion und ihrer Programmierung zunächst keinerlei spezifische Auslegung aufweisen. Erst durch eine vorgenommene Programmierung lässt sich die universelle Datenverarbeitungseinrichtung zur Ausführung spezifischer Funktionen ertüchtigen.

Insofern die Datenverarbeitungs-Cloud mehrere einzelne Komponenten aufweist, sind diese auf geeignete Weise zur Datenkommunikation miteinander verbunden, beispielsweise durch ein Kommunikationsnetzwerk. Einer Datenverarbeitungs-Cloud können beliebige Daten zur Datenspeicherung und/oder Verarbeitung zugeführt werden. Die Datenverarbeitungs-Cloud selbst stellt die gespeicherten Daten und/oder die Ereignisse der durchgeführten Datenverarbeitung wiederum anderen Geräten, beispielsweise mit einer Datenverarbeitungs-Cloud verbundenen Computerarbeitsstationen, Laptops, Smartphones zur Verfügung. Eine Datenverarbeitungs-Cloud kann beispielsweise durch ein Rechenzentrum oder auch mehrere vernetzte Rechenzentren bereitgestellt werden. Üblicherweise ist eine Datenverarbeitungs-Cloud räumlich entfernt von den Transformatoren ausgebildet.

Die Verbindung zwischen Kommunikationseinheit und Datenverarbeitungs-Cloud erfolgt über eine Fernbereichs-Kommunikationsverbindung. Um diese herzustellen, verfügt die Kommunikationseinheit über eine Fernbereichs-Kommunikationseinrichtung, wie beispielsweise ein Mobilfunkmodul nach GPRS- oder UMTS-Standard auf. Mit diesem wird eine Fernbereichskommunikationsverbindung, vorzugsweise eine IPbasierte Datenverbindung, mit der Datenverarbeitungs-Cloud aufgebaut. Dabei kann beispielsweise ein Anbieter eines Mobilfunkdienstes oder ein Telekommunikationsanbieter zwischengeschaltet sein und die Fernbereichskommunikationsverbindung kann zumindest teilweise über ein Kommunikationsnetz dieses Anbieters und/oder zumindest teilweise über das Internet hergestellt werden. Zur Herstellung der Verbindung fällt dann ein nur sehr geringer Konfigurations- beziehungsweise Parametrieraufwand an. Außer der Konfigurierung der Fernbereichs-Kommunikationseinrichtung mit den für den Aufbau der Fernbereichskommunikations-Verbindung notwendigen Informationen, z.B. den Einbau einer SIM-Karte eines Telekommunikationsanbieters, muss für die einzelne Kommunikationseinheit kein weiterer Aufwand betrieben werden.

Im Rahmen der Erfindung kann sich ein Nutzer mit Hilfe von Zugangsdaten oder mit anderen Worten Log-In-Daten bei der Datenverarbeitungs-Cloud anmelden. Die Datenverarbeitungs-Cloud erkennt anhand der Nutzerdaten, welche Transformatoren beziehungsweise welche Kommunikationseinheiten für den Nutzer relevant sind. Hierzu verfügt die Datenverarbeitungs-Cloud über eine zweckmäßige Datenbank, die auf einen Speicher der Datenverarbeitungs-Cloud abgelegt ist. Ist der Nutzer beispielsweise ein Betreiber eines bestimmten Bereichs oder eines Energieversorgungsnetzes, erkennt die Datenverarbeitungs-Cloud beispielsweise, dass der Nutzer zehn Transformatoren, betreibt. Jedes dieser Transformatoren weist Sensoren auf, die mit wenigstens einer Kommunikationseinheit verbunden sind. Nur mit diesen Kommunikationseinheiten, die im Folgenden als ausgewählte Kommunikationseinheiten bezeichnet sind, setzt sich die Datenverarbeitungs-Cloud im Rahmen der Erfindung in Verbindung.

Die Datenverarbeitungs-Cloud verfügt zweckmäßigerweise über eine Datenbank, mit deren Hilfe sich ermitteln lässt, welche Transformatoren dem jeweiligen Nutzer der Datenverarbeitungs-Cloud zugeordnet ist. In der Tabelle sind weitere Daten hinterlegt, die eine Verbindung zwischen der Datenverarbeitungs-Cloud und den ausgewählten Kommunikationseinheiten ermöglicht.

Ein Transformator im Rahmen der Erfindung ist für einen Betrieb im Hochspannungsnetz ausgelegt, d.h. für eine Betriebsspannung zwischen 1 kV und 1000 kV, insbesondere 50 kV und 800 kV. Das Hochspannungsnetz ist bevorzugt ein Wechselspannungsnetz. Aber auch ein Gleichspannungsnetz und/oder eine Kombination aus Wechsel- und Gleichspannung-netz sind im Rahmen der Erfindung möglich.

Um auf die vor dem Abfragezeitpunkt liegenden Messwerte und/oder daraus abgeleiteten Werten bereitstellen zu können, ist wenigstens eine Speichereinheit notwendig. Diese Speichereinheit ist im Rahmen einer Weiterentwicklung der Erfindung beispielsweise in der Kommunikationseinheit vorgesehen. Gemäß dieser Variante der Erfindung ist es nicht notwendig, permanent eine Fernbereichskommunikationsverbindung zwischen Kommunikationseinheit und Datenverarbeitungs-Cloud aufrecht zu erhalten. Im Rahmen dieser Weiterentwicklung können die Messwerte oder daraus abgeleitete Werte lokal abgespeichert werden. Die lokal gespeicherten Werte werden dann bei der nächsten Verbindung mit der Datenverarbeitungs-Cloud an diese gesendet.

Bei einer weiteren Variante der Erfindung werden vor dem Abfragezeitpunkt erfasste Messwerte und/oder von diesen abgeleitete Werte auf einem Speicher der Datenverarbeitungs-Cloud abgelegt. Gemäß dieser vorteilhaften Weiterentwicklung weist entweder nur die Datenverarbeitungs-Cloud oder die Datenverarbeitungs-Cloud zusätzlich zu den Kommunikationseinheiten eine Speichereinheit auf. Diese zentrale Speichereinheit dient zum Abspeichern der Messwerte und/oder daraus abgeleiteten Werten z.B. nachdem eine Fernbereichs-Kommunikationsverbindung zwischen Kommunikationseinheit und Datenverarbeitungs-Cloud durch den Nutzer am Abfragezeitpunkt hergestellt wurde. Abweichend davon kann sich die Datenverarbeitungs-Cloud in festen Intervallen mit jeder Kommunikationseinheit in Verbindung treten, um auf lokal gespeicherten Daten zuzugreifen, um diese auf der größeren zentralen Speichereinheit abzulegen. Ein Überlaufen der lokalen Speicher der Kommunikationseinheiten ist somit vermieden.

Gemäß einer weiteren Variante der Erfindung besteht fortwährend eine Fernbereichskommunikationsverbindung zwischen den Kommunikationseinheiten und der Datenverarbeitungs-Cloud, so dass die Messwerte und/oder daraus abgeleitete Werte fortwährend zur Speichereinheit der Datenverarbeitungs-Cloud übertragen und dort gespeichert werden, um im Abfragezeitpunkt mit anderen Daten, Werten oder Informationen zeitaufgelöst dargestellt werden zu können.

Zugangsdaten sind hier beispielsweise übliche Log-In-Daten. So bestehen die Zugangsdaten beispielsweise aus einem Benutzernamen und einem Passwort, das dem Benutzernamen individuell zugeordnet ist.

Vorteilhafterweise werden mittels einer Antenne zur Positionsbestimmung, die in der Kommunikationseinheit angeordnet ist, die geografische Lage der jeweiligen Kommunikationseinheit und des damit verbundenen Transformators ermittelt und auf Grundlage der geografischen Daten die Wetterbedingungen von einem Wetternachrichtendienst ermittelt. Gemäß dieser vorteilhaften Weiterentwicklung müssen die Wetterbedingungen Vorort nicht aufwändig erfasst werden. Vielmehr kann im Rahmen der Erfindung auf ohnehin - z.B. im Internet - vorhandene Daten zurückgegriffen werden. Die auf diese Weise gewonnenen Daten über die Wetterbedingungen können bei der Berechnung der tatsächlichen Lebensdauer ebenfalls berücksichtig werden.

Gemäß einer vorteilhaften Weiterentwicklung weist die Datenverarbeitungs-Cloud eine Speichereinheit auf, auf der fortwährend Messwerte und/oder aus den Messwerten abgeleitete Werte gespeichert werden, die von den Kommunikationseinheiten über eine Fernbereichs-Kommunikationsverbindung übermittelt werden. Die Fernbereichs-Kommunikationsverbindung kann, wie bereits weiter oben ausgeführt wurde, fortwährend oder mit anderen Worten permanent sein. Abweichend davon ist es im Rahmen der Erfindung jedoch auch möglich, die Fernbereichs-Kommunikationsverbindung in bestimmten Intervallen aufzubauen, um Datenblöcke aus Messwerten, die zwischen Abfrageintervallen erfasst und lokal gespeichert wurden, zu übertragen.

Vorteilhafterweise ist jede Kommunikationseinheit mit einer Antenne zur Positionsbestimmung ausgerüstet.

Weitere zweckmäßige Ausgestaltungen und Vorteile der Erfindung sind Gegenstand der nachfolgenden Beschreibung von Ausführungsbespielen der Erfindung unter Bezug auf die Figuren der Zeichnung, wobei gleiche Bezugszeichen auf gleichwirkende Bauteile verweisen und wobei
- Figur 1: eine Überlastkurve eines Transformators gemäß dem Stand der Technik,
- Figur 2: eine schematische Darstellung eines Ausführungsbeispiels des erfindungsgemäßen Verfahrens und
- Figur 3: einen Transformator mit Kommunikationseinheit und Datenverarbeitungs-Cloud schematisch verdeutlichen.

Figur 1 zeigt ein Ausführungsbeispiel einer bereits weiter oben eingeführten Überlastkurve eines Transformators, wobei auf der Abszisse die Zeit in Stunden und auf der Ordinate die Auslastbarkeit des besagten Transformators bezogen auf die Nennleistung abgetragen sind. Die gezeigte Überlastkurve wurde nach der Herstellung des ihr zugeordneten Transformators auf Grundlage von Probemessungen am besagten Transformator angefertigt und dem Kunden zur Verfügung gestellt.

In dem in Figur 1 gezeigten Ausführungsbeispiel kann der besagte Transformator 2 Stunden lang mit einer Überlast von 120% bezogen auf die Nennleistung (100%) betrieben werden. Anschließend ist ein Betrieb mit einer Überlast von 110% über 3 Stunden hinweg möglich.

Dabei wird davon ausgegangen, dass der Überlastbetrieb jeweils, also 2 Stunden mit 120% der Nennleistung und 3 Stunden mit 11% der Leistung, konstant erfolgt. Dies ist jedoch in der Realität nicht der Fall. Vielmehr wird der Transformator über die besagten 2 Stunden hinweg nicht kontinuierlich mit 120% Überlast betrieben. Vielmehr kommt es zu Schwankungen in den besagten 2 Stunden. So ist beispielsweise in der Realität ein Betrieb von über 20 Minuten hinweg bei Nennleistung, ein Betrieb über 10 Minuten bei 80% der Nennleistung, über 30 Minuten hinweg bei 70% der Nennleistung und bei 60 Minuten lang mit einer Überlast von 120% der Nennleistung möglich. Diese unterschiedliche Belastung wirkt sich selbstverständlich auf die Lebensdauer, bzw. die Alterung des Transformators aus. Mit anderen Worten wird das Potential des Transformators nicht vollständig ausgeschöpft.

Transformatoren sind Schlüsselkomponenten elektrischer Versorgungsnetze. Der Ausfall eines Transformators kann zu extremen Einbußen und sogar zu Netzausfällen führen. Transformatoren werden daher gut überwacht. Um die Alterung eines Transformators festzustellen wird beispielsweise eine Fieberkurve des Transformators aufgenommen, um auf diese Weise Informationen über die aktuelle Belastung und Lebensdauer zu gewinnen.

Aus dem ICE-Standard 60076-7 ist bekannt, eine Alterungsrate eines elektrischen Transformators in Abhängigkeit der so genannten Hotspot-Temperatur zu berechnen. Bei der Berechnung wird insbesondere das Isolationspapier der Wicklungen berücksichtigt. Dabei wird näherungsweise angenommen, dass die isolierenden Eigenschaften des Isolierpapiers neben anderen Einflussgrößen von dem Polymerisationsgrad des Isolierpapiers abhängig sind. Die beim Betrieb des Transformators entstehenden Belastungen verändern jedoch den Polymerisationsgrad des Isolierpapiers dahin, so dass die Isolationsfähigkeit des Wicklungspapiers mit zunehmender Lebensdauer abnimmt und schließlich unzureichend wird, sodass der Transformator das Ende seiner Lebensdauer erreicht.

Die Hot-Spot- oder Heißpunkttemperatur kann aus Messungen der Temperatur des Isolierfluids und aus der Messung des Wicklungsstromes ermittelt werden. Wie bereits weiter oben ausgeführt ist, kann aus der Hot-Spot Temperatur die Lebensdauer des Transformators ermittelt werden.

Die Erfindung beruht auf der Idee, dass die Öltemperatur und der Wicklungsstrom ohnehin fortwährend beobachtet werden. Es ist im Hinblick auf die Digitalisierung darüber hinaus wahrscheinlich, dass diese Messgrößen oder davon abgeleitete Daten von dem jeweiligen Transformator zu einer Datenverarbeitungs-Cloud übertragen werden, wobei die Datenverarbeitungs-Cloud aus dem ihr zur Verfügung gestellten Daten fortwährend die Lebensdauer des besagten Transformators ermittelt und diese Größe, beispielsweise einem Lastvorhersagemodell, zur Verfügung stellen kann.

Figur 2 zeigt ein Ausführungsbeispiel des erfindungsgemäßen Verfahrens 1, dass in Figur 2 schematisch dargestellt ist. Es ist ein Lastvorhersagemodell 2 gezeigt, dass zu einem Anfragezeitpunkt eine Lastvorhersageanfrage 2 erhält. Die Lastvorhersageanfrage 2 beinhaltet die Frage, mit wieviel Überlast kann der Transformator in 2 Stunden 8 Stunden lang betrieben werden, wenn der Lebensdauerverbrauch bei 110% liegen soll. Hierbei wird sich auf den Lebensdauerverbrauch bezogen (100%), der bei einem Betrieb des Transformators unter Nennleistung entsteht.

Dem Lastvorhersagemodell 2 werden darüber hinaus Zustandsparameter 4 übermittelt, wobei die Zustandsparameter 4 in dem gezeigten Ausführungsbeispiel die Temperatur des Isolierfluids im oberen Bereich des Transformators und den Wicklungsstrom umfassen. Weiter Zustandsparameter beziehen sind auf die zur Verfügung stehende Kühlleistung und die vorausgesagten Wetterbedingungen am Ort des Transformators. Darüber hinaus wird dem Lastvorhersagemodell 2 die bislang verbrauchte Lebensdauer 5 als Zustandsparameter zugeführt.

Die bereits verbrauchte Lebensdauer ist im Rahmen der Erfindung keineswegs grob abgeschätzt. Vielmehr wird die verbrauchte Lebensdauer fortwährend an Hand von Messwerten ermittelt und auf einer Speichereinheit 6 abgelegt. Auf Grundlage der so erfassten Lebensdauer oder mit anderen Worten des so erfassten Lebensdauerverbrauchs ist es im Rahmen der Erfindung möglich, dass das Lastvorhersagemodell 2 die Überlastfähigkeit des Transformators genauer bestimmt.

Ausgangsseitig erzeugt das Lastvorhersagemodell zum einen die Aussage 7, dass wie hoch der maximal mögliche Überlastbetrieb in dem gewünschten Zeitraum ist. Ferner gibt das Lastvorhersagemodell den erwarteten Lebensdauerverbrauch 8 in dem gewünschten Zeitraum an.

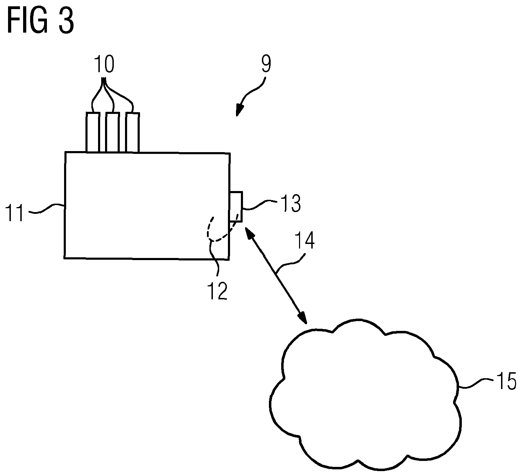

Figur 3 zeigt einen schematisch dargestellten Transformator 9 mit seinen drei Durchführungen 10, die an einem Tank des Transformators 11 abgestützt sind. An ihrem vom Tank 11 abgewandten Ende, verfügen die Durchführungen 10 über einen so genannten Freiluftanschluss zum Anschluss einer luftisolierten Hochspannungsleitung eines Energieversorgungsnetzes. Jede Durchführung 10 verfügt über einen inneren Hochspannungsleiter, der sich durch einen hohlen Isolator erstreckt. Dabei durchgreifen der Isolator und der Hochspannungsleiter die obere Wandung des Tanks des Transformators und erstrecken sich mit ihrem freien Ende in Ölraum des Tanks 11 hinein. Die Hochspannungsleiter jeder Durchführung 10 kann so mit der jeweiligen Oberspannungswicklung des Transformators verbunden werden kann. Jede Hochspannungswicklung ist konzentrisch zu einer Unterspannungswicklung angeordnet, durch die sich ein Schenkel eines magnetisierbaren Kerns erstreckt. Oberspannungs- und Unterspannungswicklungen sind so induktiv miteinander gekoppelt.

Der Tank der Transformators ist mit einem Isolierfluid befüllt ist, das zur Isolierung und zur Kühlung der beim Betrieb auf Hochspannung liegenden Wicklungen und des Kerns dient. Der Transformator weist ferner eine Kühleinheit auf, die figürlich jedoch nicht dargestellt ist.

Der Transformator 9 ist mit Temperatursensoren bestückt, die im Inneren des Tanks 11 zur Erfassung der Temperatur des Isolierfluids angeordnet sind und figürlich daher nicht dargestellt sind. Jeder Temperatursensor ist über eine Nahbereichskommunikationsverbindung 12 mit einer an dem Transformator 9 befestigten Kommunikationseinheit 13 verbunden, wobei die Nahbereichs-Kommunikationsverbindung 12 in diesem Fall als Kabel ausgeführt ist. Die Kommunikationseinheit 13 ist wiederum über eine Fernbereichs-Kommunikationsverbindung 14 mit einer Datenverarbeitungs-Cloud 15 verbunden.

Die von den Temperatursensoren erfassen Temperaturmesswerte werden über die Nahbereichs-Kommunikationsverbindung 12 zur Kommunikationseinheit 13 gesendet. Diese überträgt die Temperaturmesswerte über die Fernbereich-Kommunikationsverbindung 14 zur Datenverarbeitungs-Cloud 15. Die Datenverarbeitungs-Cloud 15 verfügt über den in Figur 2 verdeutlichten Speicher 6 und berechnet die verbrauchte Lebensdauer anhand der erfassten Temperaturmesswerte sowie der erfassten Wicklungsströme nach dem oben genannten Standard. Auf diese Art und Weise wird der Lebensdauerverbrauch des Transformators 9 fortwährend ermittelt und steht dem Lastvorhersagemodell 2 gemäß Figur 2 bei Bedarf zur Verfügung.

## Patentansprüche

1. Verfahren (1) zum Bestimmen einer maximalen Überlastfähigkeit eines Transformators, bei dem
- eine Lastvorhersageanfrage (3) für einen vorgegebenen Zeitraum erstellt,
- ein Betriebszustand des Transformators unter Gewinnung von Zustandsparametern (4) ermittelt wird,
- die Lastvorhersageanfrage (3) und die Zustandsparameter (4) in einem Anfragezeitpunkt an ein Lastvorhersagemodell (2) übertragen werden und
- das Lastvorhersagemodell (2) die maximale Überlastfähigkeit in dem vorgegebenen Zeitraum ermittelt,
**dadurch gekennzeichnet,**
- **dass** eine vor dem Anfragezeitpunkt verbrauchte Lebensdauer des Transformators von Messwerten unter Gewinnung einer tatsächlich verbrauchten Lebensdauer (5) abgeleitet wird und die tatsächlich verbrauchte Lebensdauer (5) dem Lastvorhersagemodell (2) als Zustandsparameter zugeführt wird, wobei das Lastvorhersagemodell (2) die maximale Überlastfähigkeit (7) in Abhängigkeit der tatsächlich verbrauchten Lebensdauer (5) ermittelt.

2. Verfahren (1) nach Anspruch 1,
**dadurch gekennzeichnet, dass**
die Zustandsparameter (4) einen Parameter umfassen, der die zur Verfügung stehende Kühlleistung abbildet.

3. Verfahren (1) nach Anspruch 1 oder 2,
**dadurch gekennzeichnet, dass**
die Zustandsparameter (4) einen Parameter umfassen, der die Wetterbedingungen abbildet, denen der Transformator ausgesetzt ist.

4. Verfahren (1) nach einem der vorhergehenden Ansprüche,
**dadurch gekennzeichnet, dass**
die verbrauchte Lebensdauer (5) des Transformators fortwährend berechnet und auf einer Speichereinheit (6) abgelegt wird.

5. Verfahren (1) nach einem der vorhergehenden Ansprüche,
**dadurch gekennzeichnet, dass**
die Lastvorhersageanfrage (3) eine Vorhersage der Wetterbedingungen umfasst.

6. Verfahren (1) nach einem der vorhergehenden Ansprüche,
**dadurch gekennzeichnet, dass**
die Lastvorhersageanfrage (3) eine Angabe über den gewünschten Lebensdauerverbrauch umfasst.

7. Verfahren (1) nach einem der vorhergehenden Ansprüche,
**dadurch gekennzeichnet, dass**
das Lastvorhersagemodell (2) den erwarteten Lebensdauerverbrauch (8) angibt.

8. Verfahren (1) nach einem der vorhergehenden Ansprüche,
**dadurch gekennzeichnet, dass**
Messwerte von Sensoren erfasst werden, die in oder an dem Transformator angeordnet sind, und die Betriebszustandsparameter zumindest teilweise auf Grundlage der Messwerte und/oder der davon abgeleiteten Werte erhalten werden.

9. Verfahren (1) nach einem der vorhergehenden Ansprüche,
**dadurch gekennzeichnet, dass**
Messwerte und/oder von den Messwerten abgeleitete Werte verwendet werden, die vor dem Anfragezeitpunkt erfasst beziehungsweise abgeleitet wurden.

10. Verfahren (1) nach einem der Ansprüche 8 oder 9,
**dadurch gekennzeichnet, dass**
die Messwerte und/oder davon abgeleitete Werte über eine Nahbereichs-Kommunikationsverbindung (12) von den Sensoren zu einer Kommunikationseinheit (13) des Transformators übertragen werden, wobei die Kommunikationseinheit (13) über eine Fernbereichs-Kommunikationsverbindung (14) einer Datenverarbeitungs-Cloud (15) verbindbar ist.

11. Verfahren (1) nach einem der vorhergehenden Ansprüche,
**dadurch gekennzeichnet, dass**
vor dem Abfragezeitpunkt erfasste Messwerte und/oder von diesen abgeleitete Werte auf einem Speicher der Kommunikationseinheit (13) oder der Datenverarbeitungs-Cloud (15) gespeichert werden.

12. Verfahren (1) nach einem der vorhergehenden Ansprüche,
**dadurch gekennzeichnet, dass**
mittels einer Antenne zur Positionsbestimmung, die in einer Kommunikationseinheit (13) angeordnet ist, die geographische Lage der jeweiligen Kommunikationseinheit (13) und des damit verbundenen Transformators (11) ermittelt und anschließend die Wetterdaten von einem Wetternachrichtendienst erfasst werden, die für die geografische Lage des Transformators (11) von einem Dienstleister bereitgestellt sind.

13. Computerprogramm für ein Rechengerät,
**dadurch gekennzeichnet, dass**
das Computerprogramm das Verfahren nach einem der Ansprüche 1 bis 9 ausführt.

14. Speichermedium,
**dadurch gekennzeichnet, dass**
auf ihm ein Computerprogramm nach dem Anspruch 13 gespeichert ist.

## Claims

1. Method (1) for determining a maximum overload capacity of a transformer, in which
- a load forecast request (3) is created for a predefined time period,
- an operating state of the transformer is ascertained by obtaining state parameters (4),
- the load forecast request (3) and the state parameters (4) are transmitted at a request time to a load-forecasting model (2), and
- the load-forecasting model (2) ascertains the maximum overload capacity in the predefined time period,
**characterized**
- **in that** a service life of the transformer consumed before the request time is derived from measured values by obtaining an actually consumed service life (5) and the actually consumed service life (5) is fed to the load-forecasting model (2) as a state parameter, wherein the load-forecasting model (2) ascertains the maximum overload capacity (7) depending on the actually consumed service life (5).

2. Method (1) according to Claim 1,
**characterized in that**
the state parameters (4) comprise a parameter that maps the available cooling power.

3. Method (1) according to Claim 1 or 2,
**characterized in that**
the state parameters (4) comprise a parameter that maps the weather conditions to which the transformer is exposed.

4. Method (1) according to one of the preceding claims,
**characterized in that**
the consumed service life (5) of the transformer is continuously calculated and stored on a storage unit (6).

5. Method (1) according to one of the preceding claims,
**characterized in that**
the load forecast request (3) comprises a forecast of the weather conditions.

6. Method (1) according to one of the preceding claims,
**characterized in that**
the load forecast request (3) comprises an indication of the desired service life consumption.

7. Method (1) according to one of the preceding claims,
**characterized in that**
the load-forecasting model (2) indicates the expected service life consumption (8).

8. Method (1) according to one of the preceding claims,
**characterized in that**
measured values are captured by sensors that are arranged in or on the transformer, and the operating state parameters are obtained at least partially on the basis of the measured values and/or the values derived therefrom.

9. Method (1) according to one of the preceding claims,
**characterized in that**
measured values and/or values derived from the measured values that have been captured or derived before the request time are used.

10. Method (1) according to either of Claims 8 and 9,
**characterized in that**
the measured values and/or values derived therefrom are transmitted via a short-range communication connection (12) from the sensors to a communication unit (13) of the transformer, wherein the communication unit (13) is able to be connected via a long-range communication connection (14) to a data processing cloud (15).

11. Method (1) according to one of the preceding claims,
**characterized in that**
measured values and/or values derived therefrom captured before the request time are stored on a storage device of the communication unit (13) or of the data processing cloud (15).

12. Method (1) according to one of the preceding claims,
**characterized in that**
the geographical location of the respective communication unit (13) and the transformer (11) connected to it are ascertained by means of an antenna for position determination that is arranged in a communication unit (13), and the weather data are then captured by a weather-reporting service, said data being provided by a service provider for the geographical location of the transformer (11).

13. Computer program for a computing device,
**characterized in that**
the computer program carries out the method according to one of Claims 1 to 9.

14. Storage medium,
**characterized in that**
a computer program according to Claim 13 is stored thereon.

## Revendications

1. Procédé (1) de détermination d'une capacité maximum de surcharge d'un transformateur, dans lequel
- on établit une demande (3) de prédiction de charge pendant un laps de temps donné à l'avance,
- on détermine un état de fonctionnement du transformateur en obtenant des paramètres (4) d'état,
- on transmet la demande (3) de prédiction de charge et les paramètres (4) d'état à un instant de demande à un modèle (2) de prédiction de charge, et
- le modèle (2) de prédiction de charge détermine la capacité maximum de surcharge dans le laps de temps donné à l'avance,
**caractérisé en ce que**
- l'on déduit une durée de vie du transformateur, écoulée avant l'instant de la demande, de valeurs de mesure, en obtenant une durée (5) de vie écoulée réellement et on envoie comme paramètre d'état la durée (5) de vie écoulée réellement au modèle (2) de prédiction de charge, dans lequel le modèle (2) de prédiction de charge détermine la capacité (7) maximale de surcharge en fonction de la durée (5) de vie écoulée réellement.

2. Procédé (1) suivant la revendication 1,
**caractérisé en ce que**
les paramètres (4) d'état comprennent un paramètre, qui représente la puissance de refroidissement disponible.

3. Procédé (1) suivant la revendication 1 ou 2,
**caractérisé en ce que**
les paramètres (4) d'état comprennent un paramètre, qui représente les conditions météorologiques auxquelles le transformateur est exposé.

4. Procédé (1) suivant l'une des revendications précédentes,
**caractérisé en ce que**
l'on calcule en continu la durée (5) de vie écoulée du transformateur et on la met dans une unité (6) de mémoire.

5. Procédé (1) suivant l'une des revendications précédentes,
**caractérisé en ce que**
la demande (3) de prédiction de charge comprend une prédiction des conditions météorologiques.

6. Procédé (1) suivant l'une des revendications précédentes,
**caractérisé en ce que**
la demande (3) de prédiction de charge comprend une indication sur la consommation souhaitée de la durée de vie.

7. Procédé (1) suivant l'une des revendications précédentes,
**caractérisé en ce que**
le module (2) de prédiction de charge indique la consommation escomptée de la durée (8) de vie.

8. Procédé (1) suivant l'une des revendications précédentes,
**caractérisé en ce que**
l'on détecte des valeurs de mesure par des capteurs, qui sont montés dans ou sur le transformateur, et on obtient les paramètres d'état de fonctionnement au moins en partie sur la base des valeurs de mesure et/ou des valeurs qui s'en déduisent.

9. Procédé (1) suivant l'une des revendications précédentes,
**caractérisé en ce que**
l'on utilise des valeurs de mesure et/ou des valeurs, qui se déduisent des valeurs de mesure, qui ont été détectées ou qui ont été déduites avant l'instant de la demande.

10. Procédé (1) suivant l'une des revendications 8 ou 9,
**caractérisé en ce que**
l'on transmet les valeurs de mesure et/ou des valeurs qui s'en déduisent, par l'intermédiaire d'une liaison (12) de communication en zone proche des capteurs à une unité (13) de communication, dans lequel l'unité (13) de communication peut être reliée à un nuage (15) de traitement de données, par une liaison (14) de communication en zone proche.

11. Procédé (1) suivant l'une des revendications précédentes,
**caractérisé en ce que**
l'on met des valeurs de mémoire détectées avant l'instant de la demande et/ou des valeurs qui s'en déduisent, dans une mémoire de l'unité (13) de communication ou du nuage (15) de traitement de données.

12. Procédé (1) suivant l'une des revendications précédentes,
**caractérisé en ce qu'**
au moyen d'une antenne de détermination de position, qui est montée dans l'unité (13) de communication, on détermine la position géographique de l'unité (13) respective de communication et du transformateur (11) qui y est relié, et on détecte ensuite les données météorologiques, par un service de messages météorologiques, qui sont mises à disposition par un prestataire de service pour le lieu géographique du transformateur (11).

13. Programme d'ordinateur pour un appareil de calcul,
**caractérisé en ce que**
le programme d'ordinateur exécute le procédé suivant l'une des revendications 1 à 9.

14. Support de mémoire,
**caractérisé en ce qu'**
un programme d'ordinateur suivant la revendication 13 y est mis en mémoire.
